(19) Europäisches Patentamt
European Patent Office
Office européen des brevets

(11) EP 0 703 538 A1

(12) **EUROPÄISCHE PATENTANMELDUNG**

(43) Veröffentlichungstag:
**27.03.1996 Patentblatt 1996/13**

(51) Int. Cl.$^6$: **G06F 17/50**

(21) Anmeldenummer: **94114980.9**

(22) Anmeldetag: **22.09.1994**

(84) Benannte Vertragsstaaten:
**AT BE CH DE DK ES FR GB GR IE IT LI LU MC NL PT SE**

(71) Anmelder: **SIEMENS AKTIENGESELLSCHAFT**
**D-80333 München (DE)**

(72) Erfinder: **Turban, Peter, Dipl.-Ing.**
**D-92559 Winklarn (DE)**

(54) **Verfahren zur Bestimmung der gegenseitigen induktiven Beeinflussung von mindestens zwei dreidimensionalen Leiterstrukturen in nicht magnetischer Umgebung auf einem Rechner**

(57) Die Erfindung beschreibt ein neuartiges Verfahren zur Bestimmung von Induktivitätskoeffizienten (L11,..,L66) mit Hilfe von Finiten-Elemente-Programmen. Dabei wird hauptsächlich durch nummerische Vereinfachung die Rechenzeit auf ein akzeptables Maß reduziert. Mit der Erfindung können beispielsweise in Hochgeschwindigkeitsschaltungen Leiterabstände von Leiterbahnen korrekt vorgegeben werden, oder IC-Gehäuse und deren Lead-Frames in Abhängigkeit von schaltkreistechnischen Vorgaben ausgewählt werden. Das Verfahren ist beispielsweise in CAD-Verfahren oder in Entwicklungsverfahren für Semicustom IC's einsetzbar. Es ist aber auch denkbar, daß es bei der Leiterplattenentflechtung zum One-Line-Check verwendet wird.

**Figur 1**

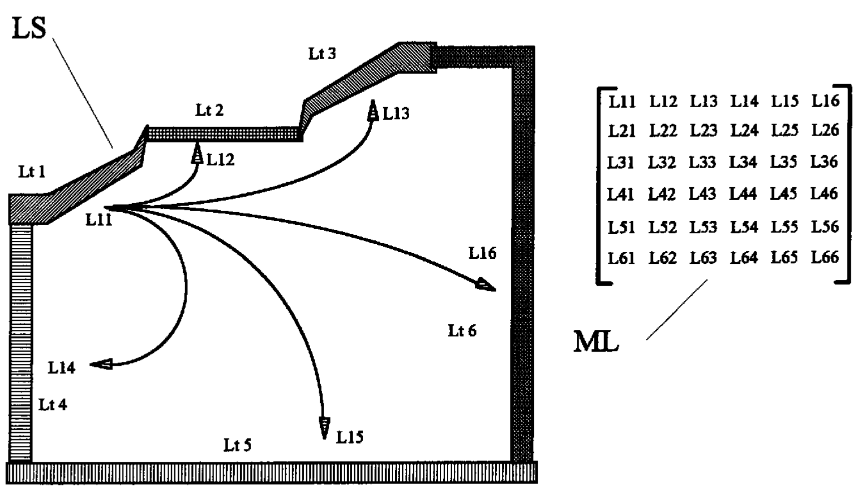


EP 0 703 538 A1

**Beschreibung**

Die Simulation elektronischer Baugruppen hat sich in den letzten Jahren zu einem wichtigen Thema entwickelt. Es wird immer wieder betont, daß die Simulation vor allem für die Qualität der entwickelten Schaltungen wichtig ist und daß die zu einer Steigerung der Produktivität führt. Dabei gewinnen mit zunehmenden Taktfrequenzen elektronischer Schaltungen die parasitären Effekte immer stärkeren Einfluß. Eine Folge davon ist die Notwendigkeit, das induktive Verhalten der einzelnen Leiterstrukturen in die Schaltungsauslegung miteinzubeziehen. Wesentlich sind hierbei die Kennwerte Induktivität und Kapazität, welche beispielsweise die Stromversorgung von IC's oder die Belastung von Ausgangstreibern maßgeblich bestimmen.

Solche dreidimensionalen Leiterstrukturen sind beispielsweise die Pins eines IC-Gehäuses. Das spezielle Problem hierbei besteht darin, daß ihnen keine Induktivität im physikalischen Sinne zugeschrieben werden kann, da die Betriebsbedingungen im geschlossenen Stromkreis nicht vorherbestimmbar sind. Dennoch kann ihr induktives Verhalten durch die sogenannten Induktionskoeffizienten charakterisiert werden, welche ein Maß für die Eigeninduktivitäten und die gegenseitige induktive Beeinflussung der einzelnen Leiterstrukturen bzw. Pins darstellen.

Zur Bestimmung der Induktionskoeffizienten ist bislang ein Verfahren bekannt, das die zu untersuchende Struktur durch mehrere Quader modelliert und die komplexe Impedanz (resistiven und induktiven Anteil) in Abhängigkeit der Frequenz berechnet. Ein Vorteil besteht darin, daß durch dieses Verfahren auch der Skin-Effekt berücksichtigt werden kann.

Nachteilig ist dabei der hohe Rechenaufwand, sowie die eingeschränkte Modellierfähigkeit [7, 8, 9]. Insbesondere ist zu beachten, daß die induktive Beeinflussung offener Leiter nur schwer gemessen werden kann, da die Messelektroden das Ergebnis erheblich verfälschen würden.Weiterer Stand der Technik ist hierzu nicht bekannt.

Das der Erfindung zugrundeliegende Problem besteht darin, ein Verfahren anzugeben, mit dem die gegenseitige induktive Beeinflussung von dreidimensionalen Leiterstrukturen durch einen Rechner sehr genau bestimmbar ist.

Diese Aufgabe wird gemäß den Merkmalen des Patentanspruches 1 gelöst.

Weiterbildungen der Erfindung ergeben sich aus den Unteransprüchen.

Ein großer Vorteil des erfindungsgemäßen Verfahrens besteht darin, daß durch Diskretisierung des der Berechnung zugrunde liegenden Doppelintegrals die Modellierung der Leiter mittels der Finite-Elemente-Methode durchgeführt wird. Dadurch können komplexe 3D-Leiterstrukturen nachgebildet werden.

Ein weiterer Vorteil des Verfahrens besteht darin, daß das Doppelintegral für die Induktionskoeffizienten in zwei Einfachintegrale aufgespalten werden konnte, welche bei geeignetem Abstand der Volumenelemente die Berechnung der induktiven Beeinflußung mit hoher Genauigkeit erlauben.
Durch die abstandsgesteuerte Berechnung der induktiven Beeinflussung kann die benötigte Rechenzeit für den Vorgang erheblich verkürzt werden.

Weiterhin wird der Rechenaufwand im erfindungsgemäßen Verfahren vorteilhaft dadurch reduziert, daß die komplex geformten Volumenelemente bei der Abstandsberechnung auf Kugeln reduziert werden und ein Näherungsradius zur Bestimmung des Abstands der Kugeln zueinander bestimmt wird. Damit kann auf einfache Weise die abstandsgesteuerte Berechnung der induktiven Beeinflussung gesteuert werden.

Vorteilhaft wird durch das erfindungsgemäße Verfahren die komplexe Form eines Volumenelementes bei der Eigeninduktivitätsbestimmung durch einen Quader angenähert. Dabei wird in vorteilhafter Weise den Randbedingungen für die Berechnung der Induktivität eines Quaders dadurch Rechnung getragen, daß der Stromdichtevektor im Mittelpunkt des Volumenelements angebracht wird und die Quaderlänge mit Hilfe der Durchstoßpunkte des verlängerten Stromdichtevektors durch die Begrenzungsflächen des Volumenelementes ermittelt wird. Dabei wird die Quaderquerschnittsfläche zunächst näherungsweise als quadratisch eingenommen und dadurch ermittelt, daß das Volumen des Volumenelementes durch die Quaderlänge dividiert wird.

Vorteilhaft wird mit dieser Fläche und dem Stromdichtevektor die Stromstärke innerhalb des Volumenelementes bestimmt und in Bezug zu der Gesamtstromstärke durch die Leiterstruktur gesetzt. Mit dem so erhaltenen Faktor wird die analytisch berechnete Quaderinduktivität skaliert.

Vorteilhaft erhält man eine noch exaktere Annäherung an ein quaderförmiges Volumenelement, indem man die Eckpunkte des Volumenelementes auf eine Fläche senkrecht zum Stromdichtevektor projiziert. Mit dem die projezierten Punkte umgebenden Polygon kann man aufgrund dessen minimaler und maximaler Querschnittsabmessungen die Flächenbegrenzungen des Quaderquerschnitts ermitteln.

Vorteilhaft werden durch das erfindungsgemäße Verfahren alle Volumenelemente einer einzelnen Leiterstruktur bezüglich ihrer Abhängigkeit untersucht, um die Eigeninduktivität der Struktur mit hoher Genauigkeit zu ermitteln.

Vorteilhaft werden durch das erfindungsgemäße Verfahren alle Volumenelemente zweier Leiterstrukturen bezüglich ihrer Abhängigkeit untersucht, um so ein möglichst genaues Maß für die induktive gegenseitige Beeinflussung zu gewinnen.

Vorteilhaft wird für die gegenseitige induktive Beeinflussung von dreidimensionalen Leiterstrukturen eine Schranke als Maß für die Begrenzung dieser Beeinflussung vorgegeben. In Abhängigkeit dieser Schranke kann dann die Leiterstruktur bzw. ein Gegenstand, auf dem diese Leiterstruktur zur Anwendung kommt, entsprechend verändert werden.

Vorteilhaft wird in Abhängigkeit dieser Schranke für die induktive Wechselwirkung beispielsweise die Geometrie einer Leiterstruktur geändert, um so der Schrankenbedingung Rechnung zu tragen.

Vorteilhaft sieht es das erfindungsgemäße Verfahren vor, der Schrankenbedingung Rechnung zu tragen, indem vom Rechner automatisch zusätzliche leitende Strukturen zur Induktivitätsverringerung eingebracht werden.

Vorteilhaft kann das erfindungsgemäße Verfahren beim automatischen Layout von Leiterbahnen einer Leiterplatte verwendet werden, um beispielsweise Abstände von Leiterbahnen automatisch korrekt zu bestimmen.

Weiterhin kann das erfindungsgemäße Verfahren vorteilhaft bei der Bestimmung der Wechselwirkung von Anschlußpins eines IC-Gehäuses eingesetzt werden. Beispielsweise kann in vorteilhafter Weise in Abhängigkeit der induktiven Wechselwirkung zwischen den einzelnen Pins und den schaltungstechnischen Vorgaben für die Schaltung, in der ein IC eingesetzt werden soll, ein geeignetes Leadframe für die Anschlußgeometrie des IC ausgewählt werden.

Vorteilhaft kann das erfindungsgemäße Verfahren bei der Dimensionierung elektronischer Bauteile, wie z. B. Spulen, eingesetzt werden. Eine vorgegebene Eigeninduktivität zugleich mit vorgegebener induktiver Wechselwirkung mit der Umwelt wird durch Geometrieänderungen bestimmter technischer Grundbauformen nach Maßgabe des Berechnungsverfahrens erreicht.

Im folgenden wird die Erfindung anhand von Figuren weiter erläutert.

Figur 1 zeigt dabei eine Leiterstruktur aus mehreren dreidimensionalen Leitern.
Figur 2 zeigt mehrere dreidimensionale Leiterstrukturen.
Figur 3 zeigt Volumenelemente und Stromdichtevektoren, die nach dem Finite-Elemente-Verfahren berechnet wurden.
Figur 4 verdeutlicht die Berechnung des Eigenanteils eines Elementes.
Figur 5 zeigt ein Volumenelement mit Durchstoßpunkten und einem Stromdichtevektor.
Figur 6 zeigt ein Lead-Frame eines IC, welches mit einem Finite-Elemente-Netz überzogen wurde.

Figur 1 zeigt zur Veranschaulichung der theoretischen Grundlagen, wie die Beschreibung der induktiven Kopplung zwischen mehreren Leiterstrukturen innerhalb eines Stromkreises LS erfolgt. Die Angabe der induktiven Wechselwirkung der einzelnen Leiterstrukturen Lt1 bis Lt6 erfolgt dabei durch die sog. Induktionskoeffizienten. Dabei spielt es keine Rolle, ob es sich bei den Einzelleitern um geschlossene Stromschleifen, oder um offene Leiterabschnitte handelt. Es soll hier aber darauf hingewiesen werden, daß im statischen Fall reale Ströme immer geschlossen sind, und die physikalisch wirksame Induktivität stets vom gesamten Stromverlauf abhängig ist.

Unter der Voraussetzung, daß die Leiter aus nichtmagnetischem Material bestehen, und in ihrer Umgebung sich keine magnetisierbare Materie befindet, können die Induktionskoeffizienten mit der folgenden Integralformel berechnet werden ([1], S. 127ff):

$$L_{\mu\nu} = \frac{\mu_0}{4\pi\, I_\mu\, I_\nu} \int_{G_\mu} \int_{G_\nu} \frac{\vec{J}_\mu \cdot \vec{J}_\nu}{r_{\mu\nu}}\, dV_\nu\, dV_\mu \qquad (1.1)$$

Dabei bedeuten:
$\mu,\nu$ Indizes für zwei Einzelleiter bzw. Leiterabschnitte
$L_{\mu\nu}$ Induktionskoeffizient der Einzelleiter $\mu$ und $\nu$
$I_\mu, I_\nu$ Stromstärken in den Einzelleitern $\mu$ und $\nu$
$\mu_0$ magnetische Feldkonstante (in Luft)
$G_\mu, G_\nu$ Volumengebiete der Einzelleiter $\mu$ und $\nu$
$dV_\mu, dV_\nu$ infinitesimale Volumenelemente der Integrale

$$\vec{J}_\mu, \vec{J}_\nu$$

Stromdichten am Ort der Volumenelemente $dV_\mu, dV_\nu$
$r_{\mu\nu}$ Abstand der Volumenelemente $dV_\mu, dV_\nu$
Die jeweiligen Wechselwirkungen zwischen den einzelnen Leiterstrukturen sind mit Pfeilen dargestellt, welche mit den zugehörigen Nummern versehen sind. Sie lassen sich in einer Matrix LS darstellen.

Diese besitzt folgende Eigenschaften:

- Symmetrie bzgl. μ und ν: es gilt $L_{\mu\nu} = L_{\nu\mu}$
- im Fall μ = ν sind $G_\mu, G_\nu$ identische Gebiete: $L_{\mu\mu}$ kann dann als "Eigeninduktionskoeffizient" des Leiters verstanden werden
- die Elemente auf der Hauptdiagonalen ($L_{\mu\mu}$) sind immer positiv
- die Elemente der Nebendiagonalen ("Gegeninduktionskoeffizienten") können positiv oder negativ sein.

Gl. (1.1) wird mittels Diskretisierung zur numerischen Berechnung in eine Doppelsumme übergeführt, welche die Ausgangsbasis für die Bestimmung der Induktionskoeffizienten nach dem erfindungsgemäßen Verfahren bildet:

$$L_{\mu\nu} = \frac{\mu_0}{4\pi\, I_\mu\, I_\nu} \sum_{m \text{ in } G_\mu} \sum_{n \text{ in } G_\nu} \frac{\bar{J}_m \cdot \bar{J}_n}{r_{mn}}\, \Delta V_m\, \Delta V_n \qquad (1.2)$$

Hierzu müssen mindestens zwei der Leiterstrukturen Lt1 bis Lt6 zunächst in finite Vokumenelemente unterteilt werden. Dabei ist zu unterscheiden zwischen den Indizes der Leiterstrukturen μ,ν und den Indizes ihrer Elemente m, n. Es ergeben sich beispielsweise folgende grundlegende Einzelschritte:

- Diskretisierung der Volumengebiete $G_\mu, G_\nu$ der Leiter in endliche Volumina $\Delta V_m, \Delta V_n$
- Berechnung der Stromdichteverteilung in diesen Volumina
- Abstandsberechnung
- Stromstärken in den Einzelleitern berechnen
- Summenanteile nach Abschnitten getrennt bilden und Induktionskoeffizient berechnen.

Die Diskretisierung und Stromdichteberechnung erfolgt mittels der Methode der Finiten Elemente (FEM). Damit zeigt sich ein wesentlicher Vorzug des Verfahrens: nahezu beliebig komplexe Leiterstrukturen können durch die Finiten Elemente nachgebildet werden.

Weitere Schritte des erfindungsgemäßen Verfahrens setzen auf die FEM-Daten auf. Die Summenanteile werden allerdings vorteilhaft durch geeignete Modifikationen mit höherer Genauigkeit berechnet, als durch Gl. (1.2) beschrieben. Dies wird später im Detail gezeigt.

Figur 2 zeigt als Realisierungsbeispiel drei Leiterstrukturen Lt1, Lt2 und Lt3. Diese sind beispielsweise in jeweils 406 finite Volumenelemente unterteilt worden, welche einzeln mit Nummern LTNR versehen sind. Die Volumenelemente von Lt1 haben hier die Nummern 1000 bis 1405, die von Lt2 2000 bis 2405 und die von Lt3 3000 bis 3405, so daß aus der jeweiligen Nummer sofort die Zugehörigkeit eines Elementes zur Leiterstruktur ableitbar ist. Die Kenntnis der Geometrie der Leiterstrukturen ist Voraussetzung zur Durchführung des erfindungsgemäßen Verfahrens.

Weiterhin müssen die Anschlußpunkte der Leiterstrukturen für die Stromeinspeisung festgelegt sein. Flächige und punktförmige Anschlüsse sind möglich. Dort wird bei der anschließenden Finite-Elemente-Berechnung eine konstante Spannung angenommen. Es muß Eingang und Ausgang festgelegt sein, da das Vorzeichen der Induktionskoeffizienten von der Stromrichtung abhängig ist.

Auch die elektrische Leitfähigkeit σ der vorhandenen Materialien muß bekannt sein. Davon hängt zunächst die Stromdichteverteilung ab, z.B. wenn eine Parallelschaltung aus unterschiedlichen Materialien auftritt (Stromaufteilung). Außerdem wird beispielsweise neben den Induktionskoeffizienten auch der elektrische Widerstand der Einzelleiter berechnet, der von der Leitfähigkeit und der Leitergeometrie bestimmt wird. Der Strom tritt hier bei 0V an Lt1 ein, folgt dem Verlauf von RB und tritt bei 1V aus Lt3 aus. Für das erfindungsgemäße Verfahren wurden die drei Leiterstrukturen fiktiv in Serie geschaltet um eine einheitliche Stromstärke darin sicherzustellen. Damit wird die Berechnung der induktiven Wechselwirkung vereinfacht. Diese Randbedingung RB stellt jedoch keine notwendige Voraussetzung zur Durchführung des Verfahrens dar.

Zur Durchführung des erfindungsgemäßen Verfahrens ist die Berechnung der Stromdichte innerhalb der leitenden Strukturen mit Hilfe eines Finite Elemente-Verfahrens notwendig. Dies ist mit vielen kommerziell erhältlichen Programmen möglich (unter Umständen durch Ausnutzung der Analogie Wärmeleitung - elektrische Stromleitung). Auf ein spezielles Programm wird deshalb im Weiteren nicht eingegangen. Nur die grundlegenden Schritte, die bei Anwendung der FE-Methode auftreten, werden gezeigt. Beispielsweise sind dafür die Programme ANSYS [4] und MSC/EMAS [5] geeignet.

Die Anwendung der Finite-Elemente-Methode (FEM) erfordert zunächst die Vernetzung der Leiter mittels Hexa-, Penta- und Tetraeder (= Finite Elemente). Je nach verwendetem FE-Programm können auch flächige (Drei- und Viereck) oder linienförmige Elemente (wie z.B. mit MSC/EMAS [5]) verwendet werden. Diese besitzen dann eine zugeordnete Dicke bzw. Durchmesser, sind also auch Volumenelemente. Die Modellgröße und der Rechenaufwand werden dadurch reduziert.

Aufgrund der Flexibilität der FEM können nahezu beliebig komplexe Strukturen modelliert werden. Hinzu kommt, daß die Modellerstellung mit automatischen Netzgeneratoren relativ schnell erfolgen kann. Von Vorteil ist auch eine CAD-Anbindung zur Übergabe der geometrischen Daten.

Bei der Erstellung des Netzes sollten die Elemente je nach vorhandenen Einzelleitern getrennt numeriert werden. Dies ermöglicht später die einfache Angabe bestimmter Leiterbereiche aus dem Gesamtmodell. Entsprechend kann auch die Zuordnung der elektrischen Leitfähigkeiten u. U. leichter erfolgen.

Nach Erstellung der Vernetzung werden beispielsweise die Randbedingungen des Berechnungsmodells angegeben. Dies entspricht physikalisch der Vorgabe einer Spannung an den Anschlußstellen der Leiter.

Für den weiteren Verlauf des Verfahrens, insbesondere als Voraussetzung für die Auswertungsschritte des Verfahrens, wird vorteilhafterweise folgendes Vorgehen zur Vergabe der Randbedingungen festgelegt :

- Erzeugen einer Serienschaltung aller beteiligten Leiter: entweder sind diese geometrisch sowieso verbunden, oder: durch die Vorgabe von Spannungsgleichheit zwischen dem Endpunkt des vorangehenden und Anfangspunkt des folgenden Leiters ("künstliche" Serienschaltung)
- Belegung des Anfangspunkts des ersten Leiters mit 0V, und des Endpunkts des letzten Leiters mit 1 Volt.

Obige Vorschrift ist vom Prinzip des Verfahrens her nicht zwingend, aber sie vereinfacht in vorteilhafter Weise die Berechnungen. Es sind auch andere Randbedingungen denkbar: beispielsweise kann man, statt einer Serienschaltung aller Leiter, für jeden Einzelleiter eine Spannungsdifferenz von 1 Volt vorschreiben. Es sind aber auch beliebige andere Spannungsdifferenzen, bzw. Potentiale möglich und denkbar ohne die Erfindung zu beeinträchtigen.

Mit den vorangegangenen Punkten Modellerstellung - Materialeigenschaften - Randbedingungen ist das FE-Modell nun vollständig. Die Berechnung der Stromdichte wird durchgeführt. In Bild 3 ist zur Illustration eine Pfeildarstellung der Stromdichtevektoren SV für ein Beispiel gezeigt. Deutlich sind darin auch die einzelnen Finiten Volumenelemente zu erkennen, welche hier lediglich von gleicher Größe sind. Sie besitzen auch eine Ausdehnung in x-Richtung des Koordinatensystems, welche in die Zeichenebene hinein zeigt. Wie zuvor ausgeführt kann die Form der Elemente völlig beliebig gewählt werden. Wie erkannt werden kann tritt der Strom bei E ein und bei A aus. Aus der Schwärzung und der Länge der Vektoren SV läßt sich beispielsweise eine erhöhte Stromdichte in den Ecken C1 und C2 der Leiterstruktur ablesen.

Aus der FEM-Analyse ergeben sich folgende wichtige Daten für die weiteren Verfahrensschritte der Erfindung:

- Modelldaten: Art und Lage der Eckpunkte der Finiten Elemente
- Volumina der Finiten Elemente.
- Elektrische Leitfähigkeiten der Finiten Elemente.
- Stromdichtevektoren (xyz-Komponenten) im Mittelpunkt jedes Finiten Elementes

Zur weiteren Auswertung der FEM-Daten folgt beispielsweise die Berechnung der Gesamtstromstärke I und der Einzelwiderstände.

Es gilt für die elektrische Verlustleistung $P_V$ eines Volumengebietes G (siehe [2], S. 174ff)):

$$P_V = \int_G \frac{\vec{J} \cdot \vec{J}}{\sigma} dV \qquad (2,1)$$

sowie

$$P_V = U \cdot I \qquad (2.2)$$

wobei U die angelegte Spannung und I den durchfließenden Strom bezeichnet.

Die Integralformel Gl. (2.1) wird nun durch Diskretisierung in eine Summenformel mit Hinblick auf die FE-Berechnung umgewandelt:

$$P_{V\mu} = \sum_{Elemente} \frac{\vec{J}_m \cdot \vec{J}_m}{\sigma_m} \Delta V_m \qquad (2.3)$$

Dabei bedeuten:

| | |
|---|---|
| Elemente | Alle Finiten Elemente des Leiterabschnitts μ |
| $\Delta V_m$ | Volumen des Finiten Elements Nr. m |
| $\sigma_m$ | Elektrische Leitfähigkeit des Elements Nr. m |
| $\vec{J}_m$ | Stromdichtevektor im Finiten Element Nr. m |

Da die Leiterstrukturen alle in Serie geschaltet werden, herrscht in jedem Leiter die gleiche Gesamtstromstärke, und es gilt $I_\mu = I_\nu = I$ (siehe Gl. 1.1) in diesem speziellen Fall. I bezeichnet dabei den Gesamtstrom durch alle Leiter.

Aus der Summenformel Gl. (2.3) werden die Verlustleistungen $P_{V\mu}$ für beispielsweise jede Leiterstruktur berechnet. Dabei sind alle beteiligten Größen aus der FE-Berechnung bekannt. Die Gesamtverlustleistung $P_V$ ist die Summe der Einzelverlustleistungen.

Die Spannung U wird als Randbedingung der FE-Berechnung vorgegeben und ist somit ebenfalls bekannt. Über die Beziehung Gl. (2.2) wird die Gesamtstromstärke I berechnet. Mit der Beziehung:

$$R_\mu = \frac{P_{V\mu}}{I^2} \qquad (2.4)$$

wird beispielsweise dann der elektrische Widerstand der Einzelleiter ermittelt.

Im Anschluß daran kann beispielsweise der Abstand $r_{mn}$ der jeweiligen Volumenelemente voneinander bestimmt werden. Die geometrischen Daten der Finiten Elemente dafür sind bekannt. Der Abstand $r_{mn}$ bezeichnet die Entfernung der Elementmittelpunkte der Elemente Nr. m und n. Der Elementmittelpunkt $\vec{r}_M$ eines Finiten Elements berechnet sich folgendermaßen:

$$\vec{r}_M = \frac{1}{p} \sum_{k=1}^{p} \vec{r}_k \quad , \qquad (2.5)$$

wobei

| | |
|---|---|
| p | Anzahl der Eckpunkte des Elements (4, 6 oder 8 entsprechend Tetra-, Hexa- oder Pentaeder) |
| $\vec{r}_k$ | Ortsvektor des k-ten Eckpunkts. |

bedeuten.

Der Abstand zweier Elemente m und n mit den Mittelpunkten

$$\vec{r}_{Mm} = \begin{bmatrix} r_{mx} \\ r_{my} \\ r_{mz} \end{bmatrix} \text{ und } \vec{r}_{Mn} = \begin{bmatrix} r_{nx} \\ r_{ny} \\ r_{nz} \end{bmatrix}$$

berechnet sich dann zu

$$r_{mn} = \sqrt{(r_{mx} - r_{nx})^2 + (r_{my} - r_{ny})^2 + (r_{mz} - r_{nz})^2} \ . \qquad (2.6)$$

Die Entfernung $r_{mn}$ der Elemente voneinander wird nun erfindungsgemäß bezogen auf einen "Elementradius" $\tilde{r}_m$, der dem Radius einer Kugel mit gleichem Volumen entspricht:

$$\tilde{r}_m = \sqrt[3]{\frac{3}{4\pi}\Delta V_m} \qquad (2.7)$$

mit $\Delta V_m$ als Elementvolumen. Der relative Abstand

$$A_{rel} = \frac{r_{mn}}{\tilde{r}_m} \qquad (2.8)$$

ist nun geeignet, die Bildung der einzelnen summenanteile zu steuern. Ist $A_{rel} > A_{min}$ mit geeignetem $A_{min}$, d.h. sind die betrachteten Volumina relativ weit entfernt, dann hat deren detaillierte Geometrie bei der Bildung ihres Summenanteils wenig Einfluß, so daß dieser zu

$$\Delta L_{mn} = \frac{\mu_0}{4\pi I^2}\frac{\vec{J}_m \cdot \vec{J}_n}{r_{mn}}\Delta V_n \Delta V_m \quad \text{für} \quad A_{rel} > A_{\min} \qquad (2.9)$$

ohne großen Fehler berechnet werden kann. Dies entspricht dem Anteil, den die Doppelsumme Gl. (1.2) beschreibt. In Testrechnungen hat sich ein Wert $A_{\min} = 10$ bewährt. Gilt hingegen $A_{rel} < A_{min}$ (für "benachbarte" Volumenelemente), so bestimmt deren spezifische Gestalt auch den Summenanteil. Wünschenswert ist dann eigentlich die exakte Berechnung nach Gl. (1.1), nur jetzt nicht auf die gesamte Leiterstruktur, sondern nur auf die gerade betrachteten Elemente angewandt. Für die üblichen Geometrien der Finiten Elemente kann dieses Integral aber nicht in geschlossener Form berechnet werden. Eine gute Näherung erhält man aus

$$\int_{El.m}\int_{El.n}\frac{\vec{J}_m \cdot \vec{J}_n}{r_{mn}}dV_n\,dV_m = \int_{El.m}\int_{El.n}\frac{\vec{J}_m \cdot \vec{J}_n}{|\vec{r}_m - \vec{r}_n|}dV_m\,dV_n \approx \frac{1}{2}\left(\int_{El.m}\int_{El.n}\frac{\vec{J}_m \cdot \vec{J}_n}{|\vec{r}_{Mm} - \vec{r}_n|}dV_n\,dV_m + \int_{El.n}\int_{El.m}\frac{\vec{J}_n \cdot \vec{J}_m}{|\vec{r}_{Mn} - \vec{r}_m|}dV_m\,dV_n\right)$$

Im Integranden wurde einer der beiden veränderlichen Vektoren durch den Mittelpunktsvektor $\vec{r}_M$, ersetzt, so daß das innere Integral unabhängig vom äußeren ist und für sich gelöst werden kann. Das äußere Integral wird dann auf eine Konstante angewandt, so daß sich als Wert die Konstante multipliziert mit dem Volumen ergibt. Wird noch berücksichtigt, daß die Stromdichten innerhalb der Elemente konstant sind, so erhält man letztlich als Summenanteil

$$\Delta L_{mn} = \frac{\mu_0}{4\pi I^2}\cdot(\vec{J}_m \cdot \vec{J}_n)\frac{1}{2}\left(\Delta V_m \int_{El.n}\frac{1}{|\vec{r}_{Mm} - \vec{r}_n|}dV_n + \Delta V_n \int_{El.m}\frac{1}{|\vec{r}_{Mn} - \vec{r}_m|}dV_m\right) \quad \text{für} \quad A_{rel} < A_{\min} \qquad (2.10)$$

Die verbleibenden Einzelintegrale können für polygonal berandete Volumenbereiche, also Hexa-, Penta- und Tetraeder, analytisch angegeben werden ([3]). Die Berechnung ist allerdings relativ zeitaufwendig. Zwar könnten alle Elementanteile nach Gl. (2.10) berechnet werden, ohne Berücksichtigung des Abstands. Der zusätzliche Aufwand der erfindungsgemäßen Abstandssteuerung macht sich aber durch eine beträchtliche Verkürzung der Rechenzeiten ohne wesentlichen Genauigkeitsverlust bezahlt.

Bis jetzt wurden die Summenanteile für verschiedene Elemente ermittelt. Will man nun noch den Induktivitätsanteil eines Finiten Elementes selbst ermitteln, so könnte man prinzipiell Gl. (2.10) auch anwenden für m = n. Die analytische Formel liefert trotz der Singularität des Integranden für $|\vec{r}_{Mm} - \vec{r}_m| = 0$ einen endlichen Wert. Es zeigt sich aber, daß dieser als Näherung für die Eigeninduktivität nicht brauchbar ist. Figur 4 zeigt ein Volumenelement als Quader mit Länge l, Höhe d und Breite b. Bekannt ist allerdings die Eigeninduktivität für einen quaderförmigen Leiter der Breite b, der Höhe

d, und der Länge l ([6], Gl. 15):

$$L_{Quader} = \frac{2\mu_0}{\pi}\left\{\frac{\omega^2}{24u}\left[\ln\left(\frac{1+A_2}{\omega}\right)-A_5\right]+\frac{1}{24u\omega}\left[\ln(\omega+A_2)-A_6\right]+\frac{\omega^2}{60u}(A_4-A_3)\right.$$
$$+\frac{\omega^2}{24}\left[\ln\left(\frac{u+A_3}{\omega}\right)-A_7\right]+\frac{\omega^2}{60u}(\omega-A_2)+\frac{1}{20u}(A_2-A_4)+\frac{u}{4}A_5-\frac{u^2}{6\omega}\arctan\left(\frac{\omega}{uA_4}\right)$$
$$+\frac{u}{4\omega}A_6-\frac{\omega}{6}\arctan\left(\frac{u}{\omega A_4}\right)+\frac{A_7}{4}-\frac{1}{6\omega}\arctan\left(\frac{u\omega}{A_4}\right)+\frac{1}{24\omega^2}\left[\ln(u+A_1)-A_7\right]+\frac{u}{20\omega^2}(A_1-A_4)$$
$$+\frac{1}{60\omega^2 u}(1-A_2)+\frac{1}{60u\omega^2}(A_4-A_1)+\frac{u}{20}(A_3-A_4)+\frac{u^3}{24\omega^2}\left[\ln\left(\frac{1+A_1}{u}\right)-A_5\right]$$
$$\left.+\frac{u^3}{24\omega}\left[\ln\left(\frac{\omega+A_3}{u}\right)-A_6\right]+\frac{u^3}{60\omega^2}\left[(A_4-A_1)+(u-A_3)\right]\right\} \qquad (2.11)$$

mit:

$$u=\frac{l}{b}$$
$$\omega=\frac{d}{b}$$

$$A_1=\sqrt{1+u^2};\quad A_2=\sqrt{1+\omega^2};\quad A_3=\sqrt{\omega^2+u^2};\quad A_4=\sqrt{1+\omega^2+u^2};$$
$$A_5=\ln\left(\frac{1+A_4}{A_3}\right);\quad A_6=\ln\left(\frac{\omega+A_4}{A_1}\right);\quad A_7=\ln\left(\frac{u+A_4}{A_2}\right).$$

Der Strom fließt dabei in Richtung der Längsachse und ist homogen über dem Querschnitt verteilt.

Figur 5 zeigt die Schnittpunkte DSP des Stromdichtevektors J mit den Außenflächen eines Finiten Elements mit Eckpunkten EP1 und EP2 . Ein finites Element wird jetzt erfindungsgemäß vorteilhaft durch einen Quader angenähert, und zwar quasi "in Richtung" seines Stromdichtevektors $\vec{J}_m$. Dazu werden die Schnittpunkte DSP dieses Vektors J, ausgehend vom Elementmittelpunkt VEP, mit den Außenflächen des Elements ermittelt, sowie die daraus resultierende "Schnittlänge" $\tilde{l}$ zwischen den Schnittpunkten DSP. Es kann dann ein volumengleicher Quader mit quadratischem Querschnitt als Näherung für das stromdurchflossenen Element angegeben werden: mit

$$\tilde{b}=\tilde{d}=\sqrt{\frac{\Delta V_m}{\tilde{l}}} \qquad (2.12)$$

ist nun die Quadergeometrie vollständig bekannt, und es kann die Induktivität eines Quaders der Abmessungen $\tilde{b}$, $\tilde{d}$, $\tilde{l}$ nach Gl. (2.11) berechnet werden.

Der induktive Beitrag des auf diese Weise abgebildeten Finiten Elements ergibt sich allerdings erst nach einer Skalierung über die durchfließenden Ströme. Bei der Induktivität des Quaders wird angenommen, daß der Gesamtstrom vollständig durch den Quader fließt. Das Finite Element hingegen wird von einem der Quaderquerschnittsfläche entsprechenden Strom von

$$\tilde{I}_m=|\vec{J}_m|\cdot\tilde{b}\cdot\tilde{d}$$

durchflossen. Die Induktivität erhält man dann durch

$$\Delta L_{mm} = \frac{\tilde{I}_m^{\,2}}{I^2} L_{Quader}(\tilde{b},\tilde{d},\tilde{l}) \;. \qquad (2.13)$$

Eine weiter verbesserte Näherung erhält man, wenn zusätzlich der in Richtung des Stromdichtevektors auf eine Ebene projizierte Querschnitt des Elements in Betracht gezogen wird. Es wird das die projizierten Punkte umgebende Polygon ermittelt. Dessen maximale und minimale Querschnittsabmessungen liefern nun das Seitenverhältnis

$$\frac{\tilde{b}}{\tilde{d}}$$

eines volumengleichen Quaders der Länge $\tilde{l}$. Der induktive Beitrag dieses Quaders mit rechteckiger Querschnittsfläche errechnet sich nach Gl. (2.13).

Als weiterer Verfahrensschritt kann beispielsweise ein Rechenprogramm zur Durchführung der Summation ausgeführt werden Dies liest zum Beispiel die Daten der FE-Berechnung ein. Die Angabe der Elementnummern ist hierbei zur Unterscheidung der einzelnen Leiterabschnitte nützlich. Der interne Programmablauf wird im Folgenden in Quasi-Struktogrammen als Tabellen dargestellt:
Tabelle 1 zeigt dabei die Hauptschleife über alle Leiterstrukturen als Realisierungsbeispiel des Verfahrens.

**Tabelle 1:**

| |
|---|
| Sei n die Anzahl der Lleiterstrukturen |
| Berechne alle Elementmittelpunkte und Elementradien |
| Berechne die Gesamtstromstärke und Einzelwiderstände |
| Für Index μ von 1 bis n |
|     Für Index ν von μ bis n |
|         Berechnung von $L_{\mu\nu}$ (Kap. 2.4.3) |

In einem weiter Verfahrensschritt erfolgt dann Beispielsweise die Berechnung der Gesamtstromstärke und Widerstände. Tabelle 2 zeigt ein Beispiel dafür.

**Tabelle 2:**

Leiterstrukturen mit Index $\mu$ setzen sich aus Elementen mit Elementnummern $\mu_{anf}$ .... $\mu_{ende}$ zusammen.

Für die Leiterstruktueren $\mu$ : berechne Einzelverlustleistung $P_{V\mu}$

- Setze $P_{V\mu} = 0$
- Für Laufindex m von $\mu_{anf}$ ....$\mu_{ende}$
  - $$P_{V\mu} = P_{V\mu} + \frac{\vec{J}_m \cdot \vec{J}_m}{\sigma_m} \Delta V_m$$
    (vgl. Gl. 2.3)

Berechne Gesamtverlustleistung $P_V = \sum_{\mu} P_{V\mu}$

Berechne Gesamtstrom $I = \frac{P_V}{U}$ (U = 1 Volt) (aus Gl. 2.2)

Für die Leiterstrukturen $\mu$

- Berechne Widerstand der Leiterstruktur $R_{\mu}$
  $$R_{\mu} = \frac{P_{V\mu}}{I^2}$$ (Gl. 2.4)

Bei drei Leiterstrukturen werden die Induktionskoeffizienten beispielsweise in der Reihenfolge L11, L12, L13, L22, L23, L33 entsprechend dem Ablauf im Struktogramm berechnet. Die Matrix ist symmetrisch, somit gilt: L21 = L12, L31 = L13, L32 = L23. Die Berechnung der bereits bekannten Koeffizienten unterbleibt.

Als ein weiterer Schritt des erfindungsgemäßen Verfahrens erfolgt schließlich die Berechnung des Induktionskoeffizienten. Ein Beispiel für einen Verfahrensablauf wird in Tabelle 3 gezeigt.

**Tabelle 3:**

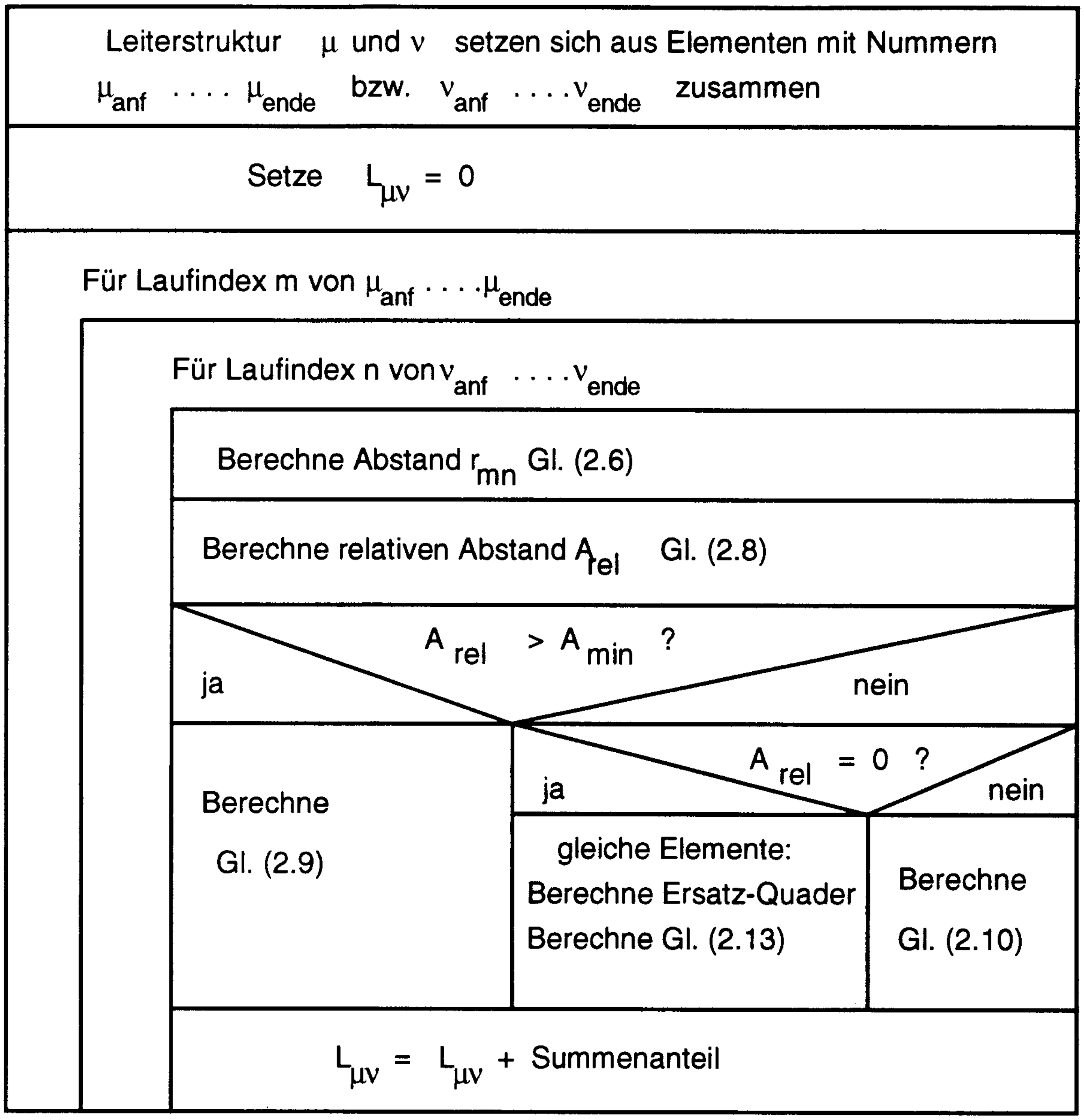


Das erfindungsgemäße Verfahren kann ohne Einschränkung auch auf nur eine einzelne Leiterstruktur angewandt werden. Dann wird nur ein einziger Koeffizient L, die Eigeninduktivität, berechnet.

Figur 6 zeigt ein Beispiel für eine technische Anwendung bei der induktiven Charakterisierung von IC-Gehäusen. Die einzelnen Pins des dargestellten Leadframes sind mit Lt1 bis Lt8 als separate Leiterstrukturen bezeichnet. Es ergibt sich hierbei folgendes grundsätzliche Problem: bei den auftretenden Leitern ("Pins") handelt es sich um offene Leiterstücke. Über den weiteren Verlauf des Stromweges, z.B. auf der Leiterplatte, können keine Annahmen gemacht werden. Einem offenen Leiter kann aber prinzipiell keine Induktivität im üblichen Sinne zugewiesen werden, d.h. als Bauteil "Spule", einer konzentrierten Induktivität.

Die Charakterisierung der Pins durch ihre Induktionskoeffizienten ist hingegen möglich. Damit erhält man ein eindeutiges, relatives Maß zum Vergleich unterschiedlicher Gehäusebauformen. Da die auftretenden Geometrien teilweise sehr komplex sind, bietet sich das erfindungsgemäße Verfahren zur Bestimmung der Induktivität hier in besonderem Maße an. Die zu berechnenden Pins wurden mittels eines automatischen Netzgenerators vernetzt. Es soll die Matrix der Induktionskoeffizienten berechnet werden.

Bei diesem Gehäuse tritt eine Besonderheit auf: die jeweils äußeren Pins Lt1 einer Seite sind im Innern des Gehäuses

kurzgeschlossen. Durch Parallelschaltung der äußeren Kontakte erhofft man sich eine geringe Zuleitungsinduktivität. Figur 6 zeigt dafür die Randbedingungen entsprechend den Vorgaben, wie sie anfangs beschrieben wurden.

Tabelle 4 zeigt die Matrix der Induktionskoeffizienten (Werte in nH):

**Tabelle 4:**

| | Pin 1 | Pin 2 | Pin 3 | Pin 4 | Pin 5 | Pin 6 | Pin 7 | Pin 8 |
|---|---|---|---|---|---|---|---|---|
| Pin 1 | 5.263 | | | | | | | |
| Pin 2 | -2.453 | 9.671 | | | | | | |
| Pin 3 | 1.474 | -4.564 | 8.180 | | | | | |
| Pin 4 | -0.959 | 2.710 | -3.654 | 6.705 | | | | |
| Pin 5 | 0.640 | -1.707 | 2.047 | -2.808 | 5.350 | | | |
| Pin 6 | -0.435 | 1.057 | -1.200 | 1.454 | -2.024 | 4.073 | | |
| Pin 7 | 0.309 | -0.614 | 0.681 | -0.787 | 0.980 | -1.450 | 3.161 | |
| Pin 8 | -0.199 | 0.231 | -0.258 | 0.297 | -0.360 | 0.477 | -0.766 | 1.922 |

Die berechneten Widerstände (Werte in mΩ):

| Pin 1 | Pin 2 | Pin 3 | Pin 4 | Pin 5 | Pin 6 | Pin 7 | Pin 8 |
|---|---|---|---|---|---|---|---|
| 1.381 | 2.726 | 2.388 | 2.038 | 1.681 | 1.304 | 1.110 | 2.056 |

Literatur

[1] G. Lautz:
"Elektromagnetische Felder"
Teubner, Stuttgart 1976, ISBN 3-519-13020-3
[2] H. Hofmann:
"Das elektromagnetische Feld: Theorie und grundlegende Anwendungen"
Springer Verlag, Wien, New York, 3. Aufl. 1986,
ISBN 3-211-81918-5 (Wien)
[3] D. R. Wilton, S. M. Rao, A. W. Glisson, D. H. Schaubert, O. M. Al-Bundak, C. M. Butler:
"Potential Integrals for Uniform and Linear Source
Distributions on Polygonal and Polyhedral Domains"
IEEE Trans. Antennas & Propagation,
Vol. AP-32, No. 3, S. 276-281, March 1984

[4] Kohnke, P.C.:
"ANSYS Engineering Analysis System Theoretical Manual" Revision 4.4, Swanson Analysis Systems, Inc., Houston,

PA

[5] MacNeal Schwendler Corporation:
"MSC/EMAS Modelling Guide"
Part Number ED/A/000/MG, Edition June 1991
[6] A. E. Ruehli:
"Inductance Calculations in a Complex Integrated Circuit Environment"
IBM Journal Research and Development,
September 1976, S. 470-481
[7] R. Kamikawai, M. Vagyu, M. Nishi, K. Nakanishi, M. Masaki, H. Johnishi:
"TRISIM1 - a Three Dimensional Electrical Parameter Analysis Program"
1987 IEEE International Conference on Computer Design:
VLSI in Computers & Processors;
[8] M. Kamon, M. Tsuk, C. Smithhisler, J. White:
"Efficient Techniques for Industance Extraction of Complex 3-D Geometries"
Proceedings of the Int. Conf. on Computer Aided Design, November 1992;
[9] R. Kamikawai, M. Nishi, K. Nakanishi, A. Masaki:
"Electrical Parameter Analysis from Three-Dimensional Interconnection Geometry"
IEEE Trans. on Components, Hybrids, and Manufacturing Techn., Juni 1985, S. 269 ff;

**Patentansprüche**

1. Verfahren zur Bestimmung der gegenseitigen induktiven Beeinflussung von mindestens zwei dreidimensionalen Leiterstrukturen in nicht magnetischer Umgebung auf einem Rechner,

   a) bei dem in einem ersten Schritt dem Rechner die Geometrie von mindestens einer ersten und einer zweiten Leiterstruktur (Lt1, Lt2) bekannt gemacht wird,
   b) bei dem in einem zweiten Schritt die Leiterstrukturen (Lt1, Lt2) auf bekannte Art in numerierte Finite Volumenelemente (VEL) unterteilt werden, wobei durch die Numerierung (LTNR) die Leiterstrukturen (Lt1, Lt2) voneinander unterschieden werden,
   c) bei dem als Randbedingung (RB) zur Berechnung von Stromdichtevektoren (SV) die Leiterstrukturen unter Berücksichtigung von im Anwendungsfall auftretenden Stromflußrichtungen fiktiv in Serie geschaltet werden und zwischen dem Eingang der ersten Leiterstruktur (Lt1) und dem Ausgang einer letzten Leiterstruktur (Lt3) eine definierte elektrische Spannung (0V, 1V) vorgegeben wird,
   d) bei dem in einem dritten Schritt auf bekannte Weise die Stromdichtevektoren (SV) für die einzelnen Volumenelemente (VEL) berechnet werden,
   e) bei dem in einem vierten Schritt über die Formel:

$$P_{V\mu} = \sum_{Elemente} \frac{\bar{J}_m \cdot \bar{J}_m}{\sigma_m} \Delta V_m$$

   für die jeweilige Leiterstruktur (Lt) die Verlustleistung bestimmt wird,
   f) bei dem aus der Verlustleistung über die Randbedingung mit Hilfe von:

$$R_{\mu} = \frac{P_{V\mu}}{I^2}$$

   der Widerstand der jeweiligen Leiterstruktur ermittelt wird,
   g) bei dem in einem weiteren Schritt aus den Ortsvektoren der Eckpunkte (EP) der Volumenelemente die Abstände (r) von einer Mehrzahl der Volumenelementmittelpunkte (VEL) voneinander ermittelt werden

h) bei dem für solche Volumenelemente, bei denen der Abstand voneinander in etwa die Größenordnung eines Volumenelementes oder kleiner beträgt, die induktive Beeinflussung nach folgender Formel ermittelt wird:

$$\Delta L_{mn} = \frac{\mu_0}{4\pi I^2} \cdot (\vec{J}_m \cdot \vec{J}_n) \frac{1}{2} (\Delta V_m \int_{El.n} \frac{1}{|\vec{r}_{Mm} - \vec{r}_n|} dV_n + \Delta V_n \int_{El.m} \frac{1}{|\vec{r}_{Mn} - \vec{r}_m|} dV_m)$$

i) bei dem für solche Volumenelemente, bei denen der Abstand voneinander mehr als die Größenordnung eines Volumenelementes beträgt, die induktive Beeinflussung nach folgender Formel ermittelt wird:

$$\Delta L_{mn} = \frac{\mu_0}{4\pi I^2} \frac{\vec{J}_m \cdot \vec{J}_n}{r_{mn}} \Delta V_n \Delta V_m$$

k) und bei dem die gesamte gegenseitige induktive Beeinflussung L12 zwischen der ersten und der zweiten Leiterstruktur (Lt1, Lt2) nach:

$$L_{12} = \sum_{m \; in \; Lt1} \sum_{n \; in \; Lt2} \Delta L_{mn}$$

mit den nach h), i) ermittelten $\Delta L_{mn}$ für m≠n bestimmt wird.

Dabei bedeuten:

| | |
|---|---|
| *Elemente* | Alle Finiten Volumenelemente der Leiterstruktur µ |
| $\Delta V_m$ | Volumen des Finiten Elements Nr. *m* |
| $\sigma_m$ | Elektrische Leitfähigkeit des Elements Nr. *m* |
| $\vec{J}_m$ | Stromdichtevektor im Finiten Element Nr. *m* |
| $\mu_0$ | magnetische Feldkonstante (in Luft) |
| $I$ | Gesamtstromstärke durch die leitenden Strukturen |
| $r_{mn}$ | Abstand der Volumenelemente $\Delta V_m$,$\Delta V_n$ |
| $G_m$,$G_n$ | Volumengebiete der Leiterstrukturen m und n |

**2.** Verfahren nach Anspruch 1, bei dem zur Abstandsberechnung der finiten Volumenelemente der Radius einer volumengleichen Kugel zu:

$$\tilde{r}_m = \sqrt[3]{\frac{3}{4\pi} \Delta V_m}$$

bestimmt wird und sich damit ein relativer Abstand zu:

$$A_{rel} = \frac{r_{mn}}{\tilde{r}_m}$$

ergibt, wobei für $A_{rel} > 10$ mindestens Schritt i) und für $A_{rel} \leq 10$ mindestens Schritt h) durchgeführt wird.

**3.** Verfahren nach einem der vorangehenden Ansprüche, bei dem für den Fall, daß m=n gilt, der Eigenanteil eines Elementes durch den Anteil eines quaderförmigen Volumenelementes mit der Breite b, der Höhe d und der Länge

l, mit folgender Formel angenähert wird:

$$L_{Quader}=\frac{2\mu_0}{\pi}\left\{\frac{\omega^2}{24u}\left[\ln\left(\frac{1+A_2}{\omega}\right)-A_5\right]+\frac{1}{24u\omega}\left[\ln(\omega+A_2)-A_6\right]+\frac{\omega^2}{60u}(A_4-A_3)\right.$$
$$+\frac{\omega^2}{24}\left[\ln\left(\frac{u+A_3}{\omega}\right)-A_7\right]+\frac{\omega^2}{60u}(\omega-A_2)+\frac{1}{20u}(A_2-A_4)+\frac{u}{4}A_5-\frac{u^2}{6\omega}\arctan\left(\frac{\omega}{uA_4}\right)$$
$$+\frac{u}{4\omega}A_6-\frac{\omega}{6}\arctan\left(\frac{u}{\omega A_4}\right)+\frac{A_7}{4}-\frac{1}{6\omega}\arctan\left(\frac{u\omega}{A_4}\right)+\frac{1}{24\omega^2}\left[\ln(u+A_1)-A_7\right]+\frac{u}{20\omega^2}(A_1-A_4)$$
$$+\frac{1}{60\omega^2u}(1-A_2)+\frac{1}{60u\omega^2}(A_4-A_1)+\frac{u}{20}(A_3-A_4)+\frac{u^3}{24\omega^2}\left[\ln\left(\frac{1+A_1}{u}\right)-A_5\right]$$
$$\left.+\frac{u^3}{24\omega}\left[\ln\left(\frac{\omega+A_3}{u}\right)-A_6\right]+\frac{u^3}{60\omega^2}\left[(A_4-A_1)+(u-A_3)\right]\right\}$$

mit

$$u=\frac{l}{b}$$

$$\omega=\frac{d}{b}$$

$$A_1=\sqrt{1+u^2};\quad A_2=\sqrt{1+\omega^2};\quad A_3=\sqrt{\omega^2+u^2};\quad A_4=\sqrt{1+\omega^2+u^2};$$
$$A_5=\ln\left(\frac{1+A_4}{A_3}\right);\quad A_6=\ln\left(\frac{\omega+A_4}{A_1}\right);\quad A_7=\ln\left(\frac{u+A_4}{A_2}\right)$$

wobei die Dimensionen des jeweiligen Volumenelementes wie folgt in Quaderdimensionen überführt werden:

- Der Stromdichtevektor wird im Volumenelementmittelpunkt angebracht und es werden in seiner Verlängerung die Durchstoßpunkte mit den Begrenzungsflächen des Volumenelementes ermittelt; die Lange dieser Strecke entspricht der Quaderlänge l.
- Die Querschnittsfläche des Quaders wird quadratisch angenommen und ergibt sich aus der Division Des Elementvolumens durch die Länge l.

,wobei der Strom durch den Quader zu :

$$I_m=|\vec{J}_m|\cdot b\cdot d$$

berechnet wird und sich daraus

$$\Delta L_{mm}=\frac{I_m^{\,2}}{I^2}L_{Quader}$$

durch Skalierung mit der Gesamtstromstärke herleitet.

4. Verfahren nach einem der Anspruch 3, bei dem b und d wie folgt ermittelt werden:

   - Die Eckpunkte des Volumenelementes werden auf eine Fläche senkrecht zum Stromdichtevektor projiziert, so daß sich ein die projizierten Punkte umgebendes Polygon ergibt
   - die maximale und minimale Querschnittsabmessung des so ermittelten Polygons werden zu b und d.

5. Verfahren nach einem der voranstehenden Ansprüche, bei dem die Gegeninduktivität durch die induktive Wechselwirkung von jedem Volumenelement (VEL) der ersten Leiterstruktur (Lt1) mit jedem Volumenelement (VEL) der zweiten Leiterstruktur (Lt2) berechnet wird.

6. Verfahren nach einem der voranstehenden Ansprüche, bei dem mindestens zwei Leiterstrukturen (Lt1, Lt2) formschlüssig aneinander grenzen.

7. Verfahren nach einem der voranstehenden Ansprüche, bei dem für die induktive Wechselwirkung zweier Leiterstrukturen eine Schrankenwert vorgegeben wird und in Abhängigkeit dieser Schranke vom Rechner mindestens der Abstand dieser Leiterstrukturen verändert wird.

8. Verfahren nach einem der Voranstehenden Ansprüche, bei dem in Abhängigkeit der induktiven Wechselwirkung zweier Leiterstrukturen vom Rechner mindestens die Geometrie einer Leiterstruktur abgeändert wird.

9. Verfahren nach einem der voranstehenden Ansprüche, bei dem dem in Abhängigkeit der induktiven Wechselwirkung zweier Leiterstrukturen vom Rechner zusätzliche leitende Strukturen zur Induktivitätsverringerung eingebracht werden.

10. Verfahren nach einem der vorangehenden Ansprüche bei dem die Wechselwirkung von Leiterbahnen einer Leiterplatte berechnet wird.

11. Verfahren nach einem der Ansprüche 1 bis 9, bei dem die Wechselwirkung von Anschlußpins eines IC-Gehäuses bestimmt wird.

12. Verfahren nach Anspruch 11, bei dem in Abhängigkeit der induktiven Wechselwirkung und von elektrischen Randbedingungen für eine Schaltung ein geeignetes Gehäuse mit geeigneter Anschlußgeometrie für das IC ausgewählt wird

13. Verfahren nach einem der vorangehenden Ansprüche, das mindestens zweimal ausgeführt wird und bei dem nach jeder separaten Ausführung die bestimmte induktive Beeinflussung mit einer Vorgabebeeinflussung verglichen wird und in Abhängigkeit eines Vergleichsergebnisses die geometrische Bauform eines Bauteils mindestens durch Geometrieänderung im Rahmen der physikalisch induktivitätsbestimmenden Größen eine Annäherung der induktiven Beeinflussung an die Vorgabebeeinflussung erreicht wird.

Figur 1

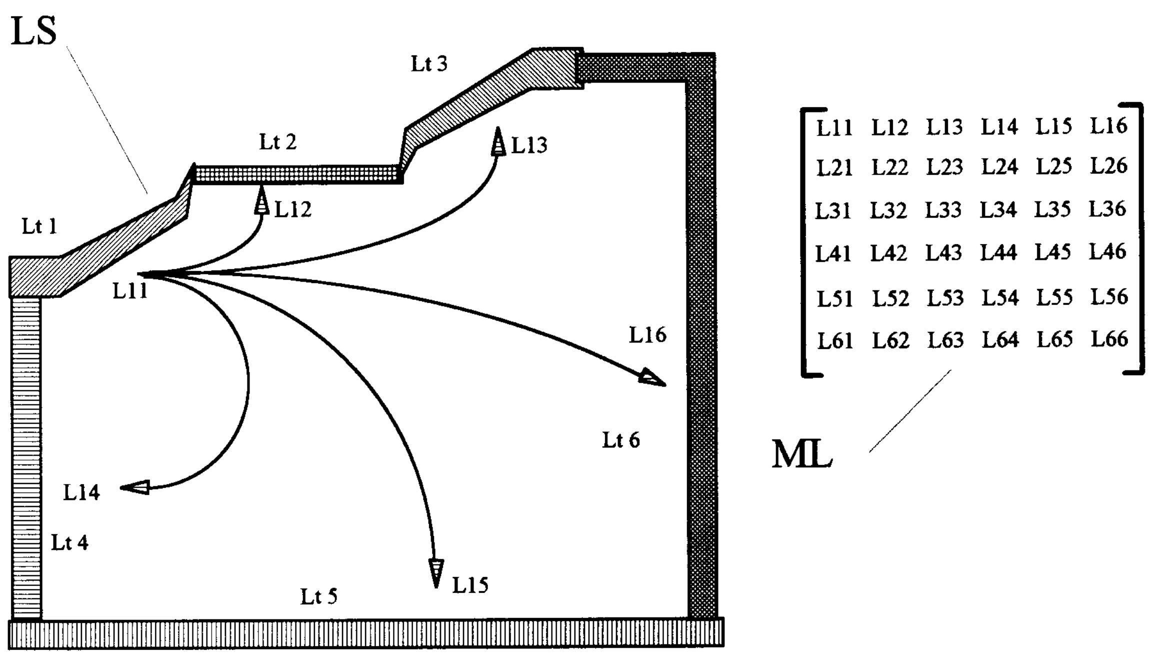


Figur 2

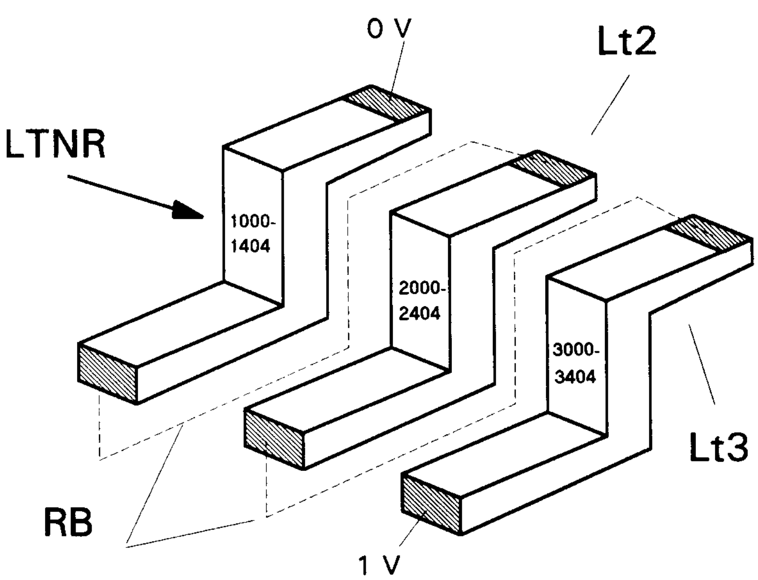

Figur 3

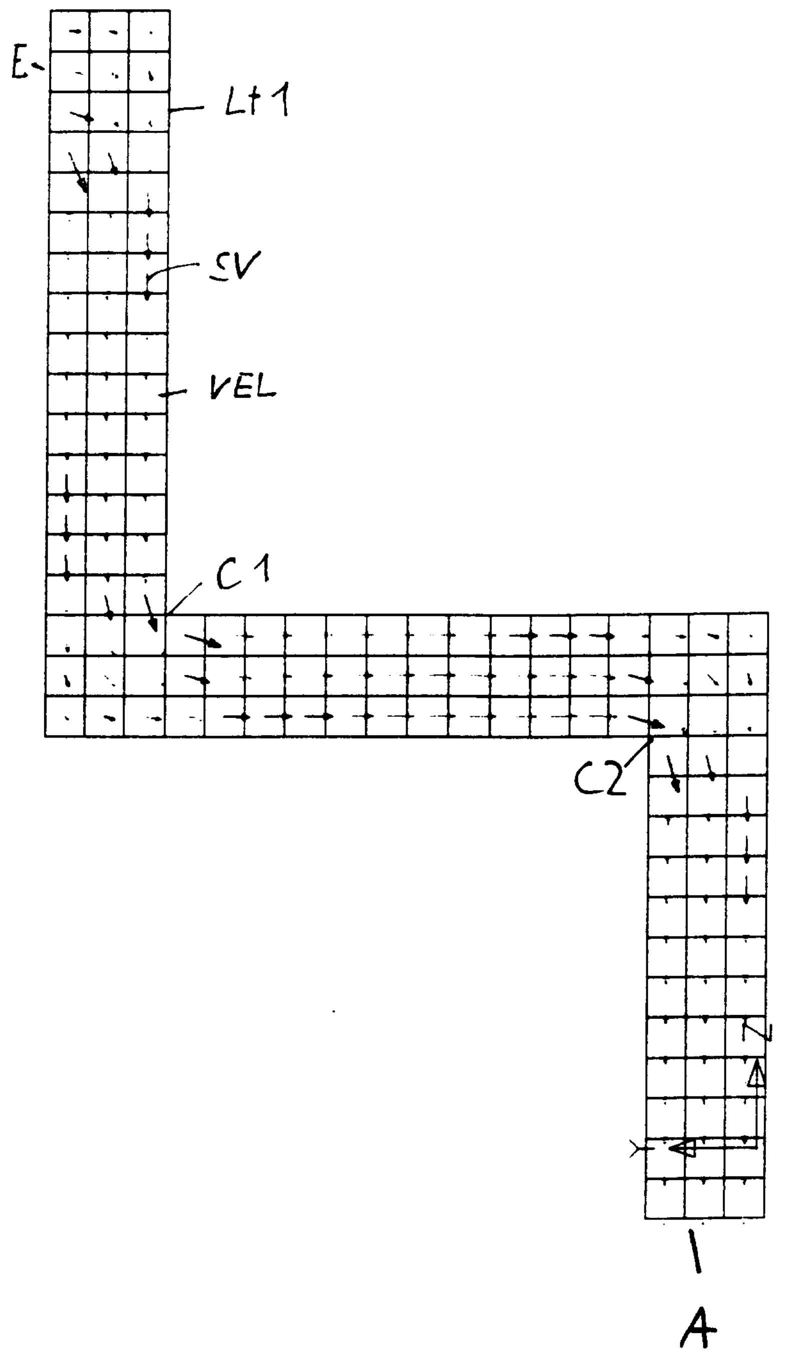

Figur 4

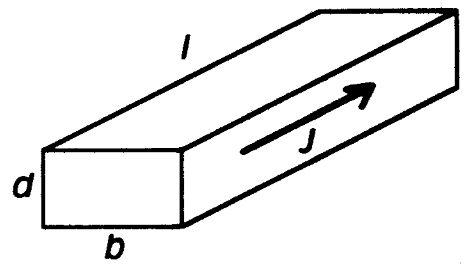


Figur 5

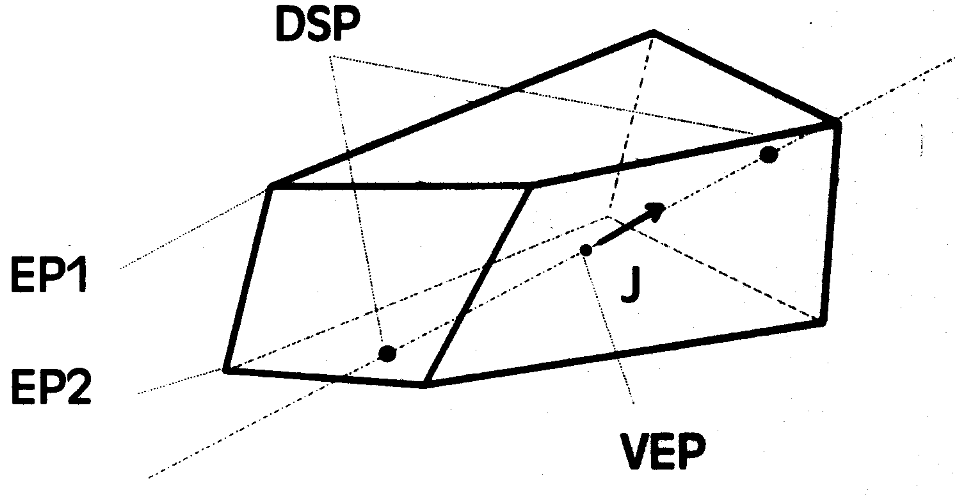

Figur 6

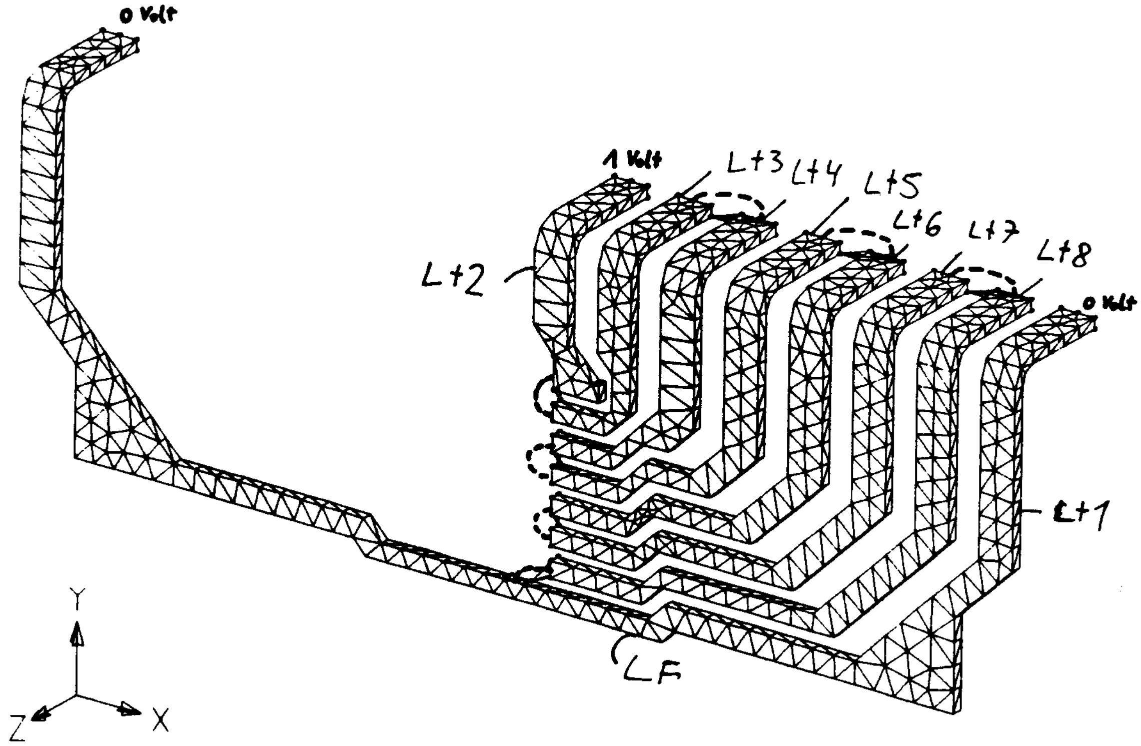

Europäisches Patentamt

# EUROPÄISCHER RECHERCHENBERICHT

Nummer der Anmeldung
EP 94 11 4980

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | 30TH DESIGN AUTOMATION CONFERENCE PROCEEDINGS, Juni 1993, US<br>Seiten 684 - 690<br>T.CHOU ET AL. 'High-Speed Interconnect Modeling and High-Accuracy Simulation Using SPICE and Finite Element Methods'<br>* Zusammenfassung; Abbildung 3 *<br>--- | 1 | G06F17/50 |
| A | IEEE TRANSACTIONS ON COMPUTER AIDED DESIGN OF INTEGRATED CIRCUITS AND SYSTEMS,<br>Bd.11, Nr.4, April 1992, NEW YORK US<br>Seiten 424 - 431<br>T.F.HAYES ET AL. 'Modeling of Multiconductor Systems for Packaging and Interconnecting High-Speed Digital IC's'<br>* Seite 426, rechte Spalte, Absatz 6 - Seite 428, linke Spalte, Absatz 2 *<br>--- | 1 | |
| A,D | 1992 IEEE/ACM INT. CONF. ON COMPUTER-AIDED DESIGN, November 1992, US<br>Seiten 438 - 442<br>M.KAMON ET AL. 'Efficient Techniques for Inductance Extraction of Complex 3-D Geometries'<br>* Zusammenfassung; Abbildung 3 *<br>--- | 1 | RECHERCHIERTE SACHGEBIETE (Int.Cl.6)<br>G06F<br>H05K<br>G01R |
| A | IEEE TRANSACTIONS ON COMPONENTS,HYBRIDS,AND MANUFACTURING TECHNOLOGY,<br>Bd.13, Nr.1, März 1990, NEW YORK US<br>Seiten 147 - 153<br>U.A.SHRIVASTAVA ET AL. 'Inductance Calculation and Optimal Pin Assignment for the Design of Pin-Grid-Array and Chip Carrier Packages'<br>* Zusammenfassung *<br>* Seite 148, linke Spalte, Absatz 2 - Seite 149, linke Spalte, Absatz 3 *<br>---<br>-/-- | 1 | |

Der vorliegende Recherchenbericht wurde für alle Patentansprüche erstellt

| Recherchenort | Abschlußdatum der Recherche | Prüfer |
|---|---|---|
| BERLIN | 9. Februar 1995 | Fritz, S |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)

Europäisches Patentamt

# EUROPÄISCHER RECHERCHENBERICHT

Nummer der Anmeldung
EP 94 11 4980

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | 1993 IEEE/ACM INT. CONF. ON COMPUTER-AIDED DESIGN, November 1993, US<br>Seiten 764 - 769<br>A.J.VAN GENDEREN ET AL. 'Hierarchical Extraction of 3D Interconnect Capacitances in Large Regular VLSI Structures'<br>* Seite 764, rechte Spalte, Absatz 1 *<br>* Seite 765, rechte Spalte, Absatz 1; Abbildung 1 *<br>--- | 1 | |
| A | EP-A-0 572 289 (SEXTANT AVIONIQUE)<br>* Zusammenfassung; Abbildungen *<br>--- | 1 | |
| A | EP-A-0 615 204 (PHILIPS)<br>* Zusammenfassung; Abbildung *<br>----- | 1 | |
| | | | RECHERCHIERTE SACHGEBIETE (Int.Cl.6) |

Der vorliegende Recherchenbericht wurde für alle Patentansprüche erstellt

| Recherchenort | Abschlußdatum der Recherche | Prüfer |
|---|---|---|
| BERLIN | 9. Februar 1995 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P04C03)